# EUROPEAN PATENT SPECIFICATION

(11) **EP 1 627 934 B1**
(45) Date of publication and mention of the grant of the patent: **21.11.2007**
(21) Application number: 05254697.5
(22) Date of filing: 27.07.2005
(51) Int. Cl.: C23C 16/26, C23C 16/515

(54) **Method for producing thin films**
Verfahren zur Herstellung von Dünnschichten
Méthode pour la fabrication de couches minces

(30) Priority: 13.08.2004 JP 2004235992
(43) Date of publication of application: 22.02.2006
(73) Proprietor: NGK INSULATORS, LTD., Nagoya-City, Aichi Pref. 467-8530 (JP)
(72) Inventor: Saito, Takao, c/o NGK Insulators, Ltd., Nagoya City, Aichi-ken 467-8530 (JP); Nakamura, Yukinori, c/o NGK Insulators, Ltd., Nagoya City, Aichi-ken 467-8530 (JP); Kondo, Yoshimasa, c/o NGK Insulators, Ltd., Nagoya City, Aichi-ken 467-8530 (JP)
(74) Representative: Paget, Hugh Charles Edward

(56) References cited:
- DE-A1- 10 055 609
- DE-C1- 19 513 614
- JP-A- 11 012 735
- HARTMANN P ET AL: "Deposition of thick diamond films by pulsed d.c. glow discharge CVD" DIAMOND AND RELATED MATERIALS, ELSEVIER SCIENCE PUBLISHERS, AMSTERDAM, NL, vol. 5, no. 6-8, May 1996 (1996-05), pages 850-856, XP004080750 ISSN: 0925-9635
- 'Handbook of Diamond like Carbon Films', NTS ISBN 4-86043-125-1 * page 308 - page 310 *
- YOSHIKAWA M.: 'Fundamentals of New Diamonds"', KOGYO CHOSA KAI * page 90 *
- STAMATE E.; HOLZER N.; SUGAI H. APPLIED PHYSICS LETTERS vol. 86, 2005, pages 261501 - 261503
- ANDERS A.: 'Handbook of Plasma Immersion Ion Implantation and Deposition', 2000, WILEY-VCH, NEW YORK * page 240 - page 253 *

## Description

This application claims the benefit of Japanese Patent Application P2004- 235992 filed on August 13, 2004, the entirety of which is incorporated by reference.

### BACKGROUND OF THE INVENTION

### 1. Field of the Invention

The present invention provides a method of producing a thin film, for example, of diamond like carbon, utilizing discharge plasma.

### 2. Related Art Statement

Japanese patent publication 11-12735A discloses a trial for forming a thin film of diamond like carbon by generating discharge plasma under a pressure near ambient pressure. According to the method, gaseous raw material is supplied to a space between opposing electrodes, and a pulse voltage is applied on the opposing electrodes to generate discharge plasma between the opposing electrodes. A thin film is thus formed. The thus obtained thin film is analyzed by Raman spectroscopic analysis, so that it is confirmed the presence of a peak value (1332 cm⁻¹) attributed to diamond, according to the description (0049) of the publication.

Japanese patent publication 2003- 328137A discloses that negative direct current pulse voltage and alternating current voltage are applied onto an electrode while gas is introduced into a vacuum container in the production of a thin film in an empty container such as resin bottle or the like. It is also disclosed that a bipolar pulse direct current power source is used as a source for applying the direct current pulse voltage. The width of the direct current pulse is in an order of µs to ms.

DE 19513614 describes a process for deposition of a carbon layer on a substrate by plasma CVD, in which the positive pulses are shorter in duration than the negative pulses. In one example, the negative pulses are 10 µs and the positive pulses 5 µs.

### SUMMARY OF THE INVENTION

So called diamond like carbon (DLC) exhibits, however, a main peak at a wave number of about 1580 cm⁻¹ and a shoulder peak at a wave number of about 1300 to 1500 cm⁻¹ or so. It is considered that the thin film described in Japanese patent publication 11-12735A is different from a normal diamond like carbon and of lower quality.

Japanese patent publication 2003- 328137A does not disclose any experiment of actually producing a thin film. The possibility of the formation and the quality of a thin film are remained unanswered. The influence of the application of bipolar direct current pulse on a thin film is not also solved.

An object of the present invention is to provide a method of forming a thin film of excellent quality by generating discharge plasma using gaseous raw material including a carbon source

The present invention provides a method of producing a thin film, as set out in claim 1.

The present inventors have found that a thin film of excellent quality can be formed by applying a pulse voltage including positive and negative pulses each having a pulse half value width of 1000 nsec or shorter in the production of a thin film by plasma CVD process.

### BRIEF DESCRIPTION OF THE DRAWINGS

Fig. 1 is a schematic view showing a system of forming a thin film available for the present invention.
Fig. 2 is a schematic view showing an example of negative and positive pulses.
Fig. 3 is a Raman spectrum of a thin film of diamond like carbon.

### Preferred embodiments of the invention

According to the present invention, plasma is generated in a space between opposing electrodes. A substrate is provided on at least one of the opposing electrodes. A separate substrate may be provided on the other of the opposing electrodes. The opposing electrodes may be of plane parallel plate type, cylinder parallel plate type, sphere parallel plate type, hyperbola parallel plate type, or coaxial cylinder type.

Either or both of the opposing electrodes may be covered with a solid dielectric material. Such solid dielectric material includes plastics such as polytetrafluoroethylene, polyethyleneterephthalate etc., a metal oxide such as a glass, silicon dioxide, aluminum oxide, zirconium dioxide, titanium dioxide etc., and a composite oxide such as barium titanate etc.

The shape of the substrate is not particularly limited. The thickness of the substrate may preferably be 0.05 to 4 mm. A distance between the opposing electrodes is not particularly limited, and may preferably be 1 to 500 mm. The substrate may be made of a material including a plastics such as polyethylene, polypropylene, polystyrene, polycarbonate, polyethylene terephthalate, polyphenylene sulfide, polyether ether ketone, polytetrafluoroethylene, an acrylic resin etc., a glass, a ceramic material and a metal. The shape of the substrate is not particularly limited and may be various three-dimensional shapes such as a plate, film or the like.

According to the present invention, the plasma state of gas can be appropriately controlled so that a thin film can be formed on the inner wall surface facing a narrow space formed in a substrate. For example, when a space having a width of 10 mm or smaller, particularly 3 mm or smaller, is formed in the substrate, a thin film can be formed on the inner wall surface facing the space. Although the shape of the space is not particularly limited, the shape may be a slit or groove.

According to the present invention, a pulse voltage is applied on the opposing electrodes to generate plasma. The wave form of each of the positive and negative pulses is not particularly limited, and may be of impulse, square wave (rectangular wave), or modulated wave type. A direct current bias voltage may preferably be applied with the application of the pulse voltage.

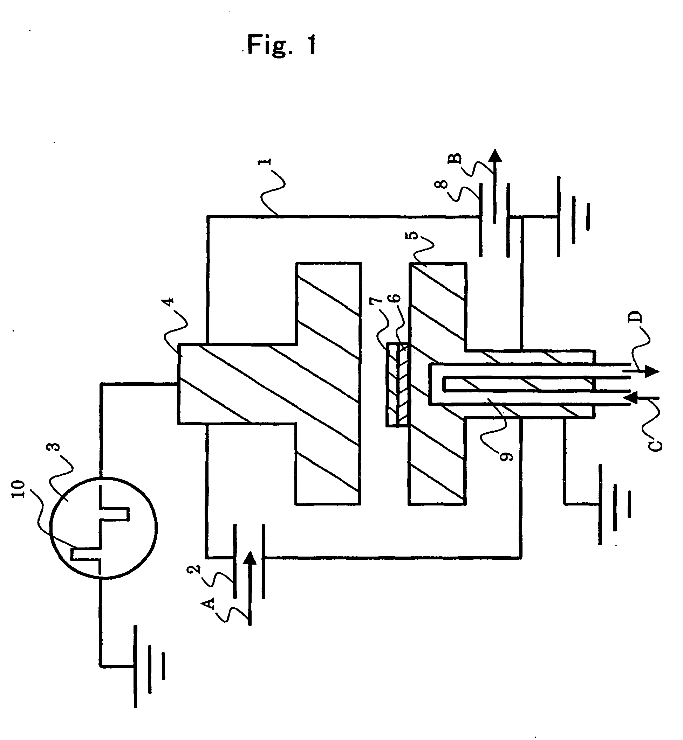

Fig. 1 is a diagram schematically showing a system usable for carrying out the present invention. A film is formed in a chamber 1. A substrate 6 is mounted on a lower electrode 5 and opposes an upper electrode 4 to form a space, where discharge plasma is generated. A gaseous raw material is supplied from a gas supply hole 2 of the chamber 1 as an arrow A into the chamber 1. A pulse voltage 10 including negative and positive pulses is applied on the upper and lower electrodes by means of an electric source 3 utilizing an static induction thyristor device to generate plasma. A thin film 7 is thus formed on the substrate 6. Used gas is discharged from a discharge hole 8 as an arrow B. A communicating route 9 of a cooling medium is formed in the lower electrode 5, so that the cooling medium is flown in the communicating route 9 as arrows C and D. It is thus possible to control the temperature of the substrate 6 at a specific value of, for example, 20 to 300 °C.

The gaseous raw material may be supplied into the chamber 1 after mixing. Alternatively, when the gaseous raw material includes two or more kinds of gases and a dilution gas, each of the gases and dilution gas may be supplied into the chamber 1 through the corresponding separate supply holes, respectively.

According to the present invention, the pattern or sequence of application of the positive and negative pulses is not particularly limited. For example, the positive pulses may be consecutively applied, and/or, the negative pulses may be consecutively applied. Alternatively, the positive and negative pulses may be alternately applied.

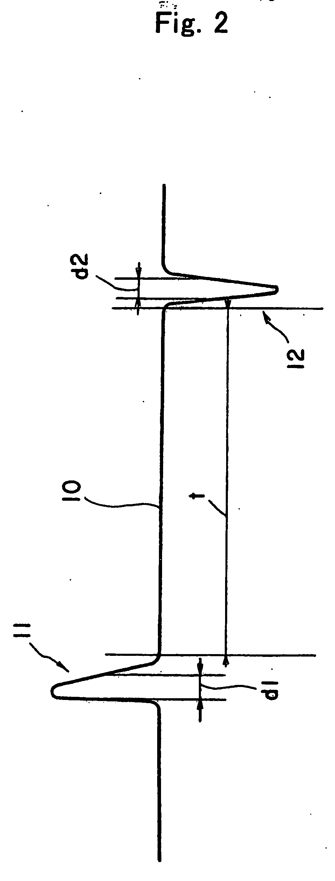

According to the present invention, it is required that each of the positive and negative pulses has a pulse half value width of 1000 nsec or smaller. It is thus possible to produce a thin film of excellent quality. For example, in the wave form of pulse voltage 10 exemplified in Fig. 2, positive pulses 11 and negative pulses 12 are applied in turns at a predetermined interval. The half value width "d1" of the positive pulse 11 and half value width "d2" of the negative pulse 12 are 1000 nsec or shorter, respectively.

On the viewpoint of forming a thin film of excellent property, the pulse half value widths "d1" and "d2" of the positive and negative pulses may preferably be 800 nsec or shorter and more preferably be 500 nsec or shorter. Although the lower limit of the pulse half value widths "d1" and "d2" are not particularly defined, the pulse half value widths may be 10 nsec or longer on the viewpoint of practical and available devices for applying the pulse voltage.

Japanese patent publication 11-12735A discloses that the pulse voltage preferably has a pulse duration time of 1 µs to 1000 µs (more preferably 3 µs to 200 µs. The pulse duration time is 20 µsec in the example. According to the description of Japanese patent publication 11-12735A, when the pulse duration time is shorter than 1 µs, the film forming becomes difficult. Japanese patent publication 2003- 328137A discloses that the width of direct current pulse is in an order of µs to ms, and no experiment of production of a thin film.

The magnitude of the positive pulse 11 is not particularly limited. For example, the field intensity between the opposing electrodes may preferably be 0.01 to 100 kV/cm and more preferably be 0.1 to 50 kV/cm.

Although the time duration "t" between the adjacent positive pulse 11 and negative pulse 12 is not particularly limited, it may preferably be 1 to 1000 µsec and more preferably be 1 to 100 µsec.

The amplitude of the negative pulse 12 is not particularly limited. For example, the field intensity between the opposing electrodes may preferably be -0.01 to -100 kV/cm and more preferably be -0.1 to -50 kV/cm.

Although the period of the positive pulse 11 is not particularly limited, it may preferably be 0.01 to 100 kHz and more preferably be 0.1 to 20 kHz.

The pulse voltage including the positive and negative pulses each having a half value width of 1000 nsec or shorter may be applied with an electric source for generating pulse with a short rise time as described above. Such electric source includes a source using a static induction thyristor device without the need of a mechanism for magnetic pressure, or a source using a thyratron equipped with a mechanism for magnetic pressure, a gap switching device, IGBT device, MOF-FET device, or a static induction thyristor device.

The pressure of the atmosphere according to the present invention is not particularly limited. The thin film is formed at a pressure of 1.3 kPa (10 Torr) or lower, on the viewpoint of forming a thin film of excellent quality. Although the lower limit of the pressure is not particularly defined, the pressure may preferably be 0.013 Pa (0.0001 Torr) or higher and more preferably be 0.13 Pa (0.001 Torr) or higher.

Gaseous raw material containing a carbon source is used in the present invention. The carbon source includes the followings.

An alcohol such as methanol, ethanol or the like.

An alkane such as methane, ethane, propane, butane, pentane, hexane or the like.

An alkene such as ethylene, propylene, betene, pentene or the like.

An alkadiene such as pentadiene, butadiene or the like.

An alkyne such as acetylene, methyl acetylene or the like.

An aromatic hydrocarbon such as benzene, toluene, xylene, indene, naphthalene, phenanthrene or the like.

A cycloalkane such as cyclopropane, cyclohexane or the like.

An cycloalkene such as cyclopentene, cyclohexene or the like.

At least one of the following gases may be used in addition to the carbon source.
(a) Oxygen gas
(b) Hydrogen gas

Oxygen and hydrogen gases are converted to atoms in the discharge plasma to remove graphite accompanied with the formation of diamond.
(c) Carbon monooxide, carbon dioxide
(d) Dilution gas

When the carbon source and carbon dioxide are used, a mixed ratio (carbon source gas/ carbon dioxide gas) may preferably be 1/1 to 1/3 (volume ratio).

The content of the carbon source in the gaseous raw material may preferably be 2 to 80 vol.%.

The content of oxygen gas or hydrogen gas in the atmosphere may preferably be 70 vol. % or lower.

The dilution gas may be at least one of gases of elements belonging to the group VIII of the Periodic Table, such as helium, argon, neon and xenon. The content of the dilution gas in the atmosphere of gaseous raw material may preferably be 20 to 90 vol. %.

Further, a gas containing boron element or phosphorus element such as diborane (BH₃BH₃), trimethyl boron (B(CH₃)₃), phosphine (PH₃), methyl phosphine (CH₃PH₂) or the like, or nitrogen gas may be added to gas atmosphere where the discharge occurs.

The thin film produced by the present invention may be composed of diamond like carbon. Alternatively, the thin film may be an amorphous silicon film (a-Si:H), or an amorphous film of BCN, BN, CN or the like.

### EXAMPLES

### (Example 1)

The system explained referring to Fig. 1 was used to produce a thin film of diamond like carbon as described above. An electric source utilizing a static induction thyristor device was used as the electric source 3. The chamber 1 and the electrode 5 were made of stainless steel. The lower electrode 5 had a diameter of 100 mm. The substrate 6 composed of a silicon substrate was mounted on the electrode 5. The upper electrode 4 was provided over the surface of the substrate 6 at a height of 200 mm. The surface of the upper electrode 4 had a diameter of 200 mm.

An oil-sealed rotary vacuum pump and an oil diffusion pump were used to evacuate the chamber 1 until the pressure in the chamber 1 reaches 1.3 × 10⁻² to 1.3 × 10⁻³ Pa (1 × 10⁻⁴ to 1 × 10⁻⁵ Torr). Acetylene gas was then supplied into the chamber 1 through the supply holes until the pressure in the chamber 1 reaches 3.1 Pa (2.3 × 10⁻² Torr). A pulse voltage was applied on the upper electrode 4 and lower electrode 5.

The positive pulse 11 and negative pulse 12 were alternately and periodically applied. The positive pulse 11 had a peak value of +8.0 kV and the negative pulse 12 had a peak value of -8.0 kV. The positive pulse had a frequency of 1 kHz, and a time duration "t" between the positive and negative pulses is 20.0 µsec. The half value width "d1" of the positive pulse 11 was 500 nsec and the half value width "d2" of the negative pulse 12 was 800 nsec. The pulse currents of the positive and negative pulses were 5.0 A and 4A, respectively.

The pulse voltage was applied so that electric discharge was maintained for 10 minutes to form a thin film 7 of diamond like carbon at a film forming rate of 0.36 µm/hour.

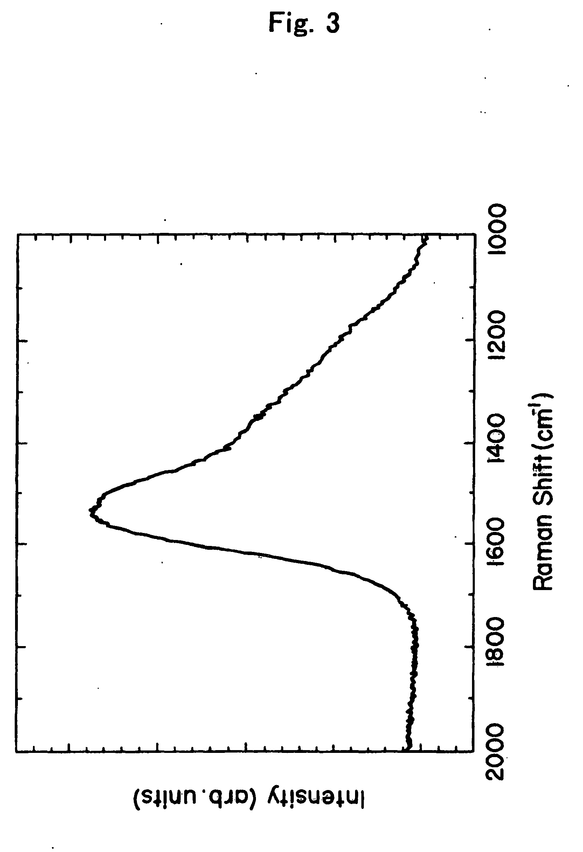

The thus obtained film was subjected to Raman spectroscopic analysis using a system for Raman spectroscopy (supplied by JASCO Corporation: " NRS-1000"). The results were shown in Fig. 3. As a result, peaks of wave numbers of about 1360 and about 1580 cm⁻¹ were observed corresponding with scattering due to diamond like carbon. It was thus proved that diamond like carbon film was formed.

### (Example 2)

A thin film of diamond like carbon was formed according to the same procedure as the example 1, except that the positive pulse 11 had a peal value of +8.0 kV, the negative pulse 12 had a peak value of -8.0 kV, the positive pulse had a frequency of 1 kHz and the time duration "t" between the positive and negative pulses was 20.0 µsec. It was proved that the half value width "d1" of the positive pulse 11 was 800 nsec, the half value width "d2" of the negative pulse 12 was 1000 nsec, the positive pulse current was 5.0A and the negative pulse current was 4 A.

The pulse voltage was applied to generate electric discharge for 10 minutes to form a thin film 7 of diamond like carbon in a rate of film formation of 0.45 µm/hour. The thus obtained film was subjected to Raman spectroscopic analysis using a system for Raman spectroscopy (supplied by JASCO Corporation: "NRS-1000"). As a result, peaks of wave numbers of about 1360 and about 1580 cm⁻¹ were observed corresponding with scattering due to diamond like carbon. It was thus proved that diamond like carbon film was formed.

### (Comparative Example 1)

A thin film of diamond like carbon was formed according to the same procedure as the example 1, except that only the negative pulse was applied with no positive pulse applied. The negative pulse 12 had a peak value of -8.0 kV, a frequency of 1 kHz and a half value width "d2" of 800 nsec, and the negative pulse current was 4A.

The pulse voltage was applied to generate electric discharge for 10 minutes to form a thin film 7 of diamond like carbon at a rate of film formation of 0.1 µm/hour. The thus obtained film was subjected to Raman spectroscopic analysis using a system for Raman spectroscopy (supplied by JASCO Corporation: " NRS-1000"). As a result, peaks of wave numbers of about 1360 and about 1580 cm⁻¹ were observed corresponding with scattering due to diamond like carbon. It was thus proved that diamond like carbon film was formed.

### (Comparative Example 2)

A thin film of diamond like carbon was formed according to the same procedure as the example 1, except that the positive pulse 11 had a peak value of + 8.0 kV, the negative pulse 12 had a peak value of -8.0 kV, the positive pulse had a frequency of 1 kHz, and the time duration "t" between the positive and negative pulses was 20.0 µsec. The half value width "d1" of the positive pulse 11 was 1200 nsec, and the half value width of the negative pulse 12 was 1200 nsec. The positive pulse current was 5.0 A and the negative pulse current was 4 A.

The pulse voltage was applied to generate electric discharge for 10 minutes to form a thin film 7 of diamond like carbon at a rate of film formation of 0.54 µm/hour. The thus obtained film was subjected to Raman spectroscopic analysis using a system for Raman spectroscopy (supplied by JASCO Corporation: " NRS-1000"). As a result, peaks of wave numbers of about 1360 and about 1580 cm⁻¹ were observed corresponding with scattering due to diamond like carbon. Although it was proved the presence of a thin film of diamond like carbon, it was also proved that the quality of the resulting film was inferior based on the observation of the spectrum. It was also proved that the diamond like carbon film exhibited the surface hazing based on the visual evaluation.

## Claims

1. A method of producing a thin film of diamond like carbon, said method comprising the step of:
applying a pulse voltage on opposing electrodes in an atmosphere having a pressure of 1.3 kPa (10 Torr) or lower, and containing gaseous raw material including a carbon source to generate discharge plasma so that said thin film of diamond like carbon is formed on a substrate, wherein said pulse voltage comprises a positive pulse and a negative pulse
**characterized in that** said positive pulse has a pulse half value width of 1000 ns or shorter and said negative pulse has a pulse half value width of 1000 ns or shorter .

2. A method according to claim 1, wherein said positive pulse has a pulse half value width of 800 ns or shorter and said negative pulse has a pulse half value width of 800 ns or shorter.

## Patentansprüche

1. Verfahren zur Herstellung einer Dünnschicht aus diamantähnlichem Kohlenstoff, wobei das Verfahren folgenden Schritt umfasst:
Anlegen einer Impulsspannung an gegenüberliegenden Elektroden in einer Atmosphäre mit einem Druck von 1,3 kPa (10 Torr) oder weniger, die ein gasförmiges Rohmaterial enthält, das eine Kohlenstoffquelle zur Erzeugung von Entladungsplasma beinhaltet, so dass die Dünnschicht aus diamantähnlichem Kohlenstoff auf einem Substrat ausgebildet wird, wobei die Impulsspannung einen positiven und einen negativen Impuls umfasst,
**dadurch gekennzeichnet, dass** der positive Impuls eine lmpulshalbwertsbreite von 1000 ns oder weniger und der negative Impuls eine Impulshalbwertsbreite von 1000 ns oder weniger aufweist.

2. Verfahren nach Anspruch 1, worin der positive Impuls eine Impulshalbwertsbreite von 800 ns oder weniger und der negative Impuls eine Impulshalbwertsbreite von 800 ns oder weniger aufweist.

## Revendications

1. Procédé de production d'un film mince de carbone de type diamant, ledit procédé comprenant l'étape consistant à :
appliquer une tension d'impulsion sur des électrodes opposées dans une atmosphère ayant une pression de 1,3 kPa (10 torr) ou inférieure, et contenant une matière première gazeuse comprenant une source de carbone pour générer un plasma de décharge de sorte que ledit film mince de carbone de type diamant est formé sur un substrat, dans lequel ladite tension d'impulsion comprend une impulsion positive et une impulsion négative,
**caractérisé en ce que** ladite impulsion positive a une largeur d'impulsion de demi-valeur de 1 000 ns ou plus courte et ladite impulsion négative a une largeur d'impulsion de demi-valeur de 1 000 ns ou plus courte.

2. Procédé selon la revendication 1, dans lequel ladite impulsion positive a une largeur d'impulsion de demi-valeur de 800 ns ou plus courte et ladite impulsion négative a une largeur d'impulsion de demi-valeur de 800 ns ou plus courte.
